# EUROPEAN PATENT SPECIFICATION

(11) **EP 2 639 342 B1**
(45) Date of publication and mention of the grant of the patent: **12.03.2014**
(21) Application number: 12196109.8
(22) Date of filing: 07.12.2012
(51) Int. Cl.: C30B 15/04, C30B 15/22, C30B 29/06

(54) **Method of manufacturing silicon single crystal**
Verfahren zur Herstellung von monokristallinem Silicium
Procédé de fabrication d'un monocristal de silicium

(30) Priority: 16.03.2012 JP 2012060179
(43) Date of publication of application: 18.09.2013
(73) Proprietor: Siltronic AG, 81737 München (DE)
(72) Inventor: Okabe, Kouji, Hikari, Yamaguchi 743-0007 (JP); Lehmann, Lothar, 09599 Freiberg (DE)
(74) Representative: Staudacher, Wolfgang

(56) References cited:
- EP-A1- 1 862 571
- JP-A- 2000 072 591
- US-A- 4 534 821
- US-A1- 2003 047 131
- US-A1- 2009 260 564
- US-B1- 6 270 575

## Description

This invention relates to a method of manufacturing a silicon single crystal and more particularly to a method of manufacturing a silicon single crystal with a Czochralski process.

### Background Art

A Czochralski process (a CZ process) has conventionally been known as a method of manufacturing a silicon single crystal. In this CZ process, a silicon single crystal is grown under a seed crystal by bringing a seed crystal in contact with a silicon melt held in a quartz crucible and thereafter pulling up the seed crystal.

With such a CZ process, when the seed crystal is brought in contact with the silicon melt, dislocation is generated in a silicon single crystal due to thermal shock or the like. In order to eliminate such dislocation (defect), what is called a dash necking step of once decreasing a diameter of a grown silicon single crystal to thereby form a neck portion is performed.

Even when such a dash necking step is performed, however, it has been difficult to completely eliminate dislocation generated in a silicon single crystal. Then, various measures have conventionally been proposed.

For example, Japanese Patent Laying-Open No. 7-206583 discloses suppression of generation of dislocation in a silicon single crystal by using a seed crystal containing an impurity at concentration as high as in a silicon single crystal to be grown for decreasing a factor of lattice mismatch between the silicon single crystal and the seed crystal. In addition, Japanese Patent Laying-Open No. 2008-290901 discloses suppression of generation of dislocation in a silicon single crystal by setting a rate of pulling up a seed crystal at the time of formation of a neck portion to 2 mm/minute or lower. Further, WO2010/146853 discloses suppression of generation of dislocation extending as far as a straight part of ingot of a silicon single crystal by varying a shape of a solid-liquid interface between a silicon single crystal grown from a seed crystal and a silicon melt at the time of formation of a neck portion with such a method as decreasing the number of revolutions of the seed crystal. According to EP 1 862 571 A1, when crystal defects are detected in the stage of growing the neck portion, the silicon single crystal is separated from the surface of the melt and again immersed into the melt for remelting. JP 2000 072596 A and corresponding US 6,270,575 B1 disclose a method, wherein the breakage of the neck is detected and a broken portion of the neck is immersed into the melt within 10 s from the detection.

According to US 2003/0047131 A1, unexpected disturbance may occur causing the diameter at the neck portion to become smaller than a target value or even such that the single crystal is separated from the surface of the melt. In such a case, the neck portion is again immersed into the melt.

US 2009/0260564 discloses a method for growing a silicon single crystal by the Czochralski method, namely by feeding silicon materials for crystal into a crucible to melt the materials to obtain a melt, and pulling up a seed crystal immersed into the melt while rotating the seed crystal to thereby grow a silicon single crystal on the lower end of the seed crystal, comprising forming a narrowingly tapered portion with a gradually decreased seed crystal diameter by pulling up the seed crystal inserted in the melt, and providing an increased neck diameter region or a decreased neck diameter region in the process of forming a neck with a constant nominal diameter in such a manner that the increased neck diameter region is provided by increasing the neck diameter, followed by decreasing the diameter, or alternatively, the decreased neck diameter region is provided by decreasing the neck diameter, followed by increasing the diameter. According to the authors of US 2009/0260564, dislocations remaining in the central axial region of the neck (on-axis dislocations) can be reliably eliminated, and a silicon single crystal absolutely free of dislocations including on-axis dislocations can be grown by this method.

### Problems to be solved by the Invention

The conventional methods described above, however, suffered the following problems. Namely, with the method disclosed in Japanese Patent Laying-Open No. 7-206583, generation of dislocation extending from a neck portion to a straight part of ingot (extending through a center of the neck portion in a direction of axis of the neck portion) cannot completely be prevented. In addition, with this method, a plurality of seed crystals should be prepared in accordance with concentration of an impurity in the silicon single crystal to be formed, and management of a manufacturing process becomes complicated. Moreover, with the method disclosed in Japanese Patent Laying-Open No. 2008-290901 as well, generation of dislocation extending from a neck portion to a straight part of ingot cannot completely be prevented. Further, with the method disclosed in WO2010/146853, such difficult process control that a shape of a solid-liquid interface between a silicon single crystal and a silicon melt is varied while crystal quality of a silicon single crystal to be grown is maintained is required and it is difficult to reliably suppress generation of dislocation with good reproducibility.

This invention was made in order to solve the problems as described above, and an object of this invention is to provide a method of manufacturing a silicon single crystal, capable of suppressing generation of dislocation extending from a neck portion to a straight part of ingot.

### Means for solving the problems

A method of manufacturing a silicon single crystal according to this invention includes the steps of preparing a silicon melt; bringing a seed crystal in contact with the silicon melt; forming a neck portion continuing from the seed, the neck portion having a formation temperature and a formation length; separating the neck portion from the silicon melt; decreasing the temperature of the neck portion separated from the silicon melt from the formation temperature to a temperature which is 740 °C or lower; bringing the neck portion having the temperature which is 740 °C or lower into contact with the silicon melt; and forming a silicon single crystal continuing from the neck portion.

### Effects of the Invention

By doing so, at the neck portion once separated from the silicon melt, even dislocation formed around the center of the neck portion is immobilized, owing to an effect of anchoring of dislocation resulting from presence of an impurity. Therefore, takeover of dislocation to a silicon single crystal grown in the step of forming a silicon single crystal continuing from the neck portion by again bringing the neck portion in contact with the silicon melt is less likely.

In addition, even in a case where dislocation around the center of the neck portion is taken over to a grown silicon single crystal when the silicon single crystal is grown, a position of the dislocation is displaced by again bringing the neck portion in contact with the silicon melt. Consequently, since outward diffusion (elimination) of the dislocation is promoted by climb of dislocation, generation of dislocation extending as far as the straight part of ingot of the silicon single crystal is suppressed. Moreover, the neck portion grown from the seed crystal has few irregularity defects because it has not been machined. Therefore, generation of dislocation from a surface of the neck portion brought in contact with the silicon melt can be suppressed in the grown silicon single crystal. Further, since a time period during which the neck portion again brought in contact with the silicon melt is held at a high temperature is also consequently longer than in a conventional example, elimination of glide dislocation is promoted as compared with the conventional example. Furthermore, the neck portion again brought in contact with the silicon melt can be smaller in area of a region in contact with the silicon melt than the seed crystal. In this case, a volume and a thermal capacity of a portion of the neck portion in contact with the silicon melt can be smaller than those of a portion of the seed crystal in contact with the silicon melt. Therefore, thermal shock generated at the time when the neck portion is brought in contact with the silicon melt is less than thermal shock generated at the time when the seed crystal is brought in contact with the silicon melt. Consequently, generation of dislocation resulting from the thermal shock is suppressed. According to this invention, generation of dislocation extending from a neck portion to a straight part of ingot can be suppressed and a high-quality silicon single crystal free from dislocation can be obtained.

Moreover, the invention can be used to grow heavy single crystals without additional mechanical systems for supporting the heavy single crystal during growth being needed. Secure holding of the heavy single crystal can be ensured by using a seed crystal having a diameter which is greater than the diameter commonly used and/or by shortening the length of the neck portion. Both, using a seed crystal having a diameter greater than that commonly used and keeping the neck portion shorter as usual will likely increase the dislocation occurrence rate. However, due to the dislocation-suppressing effect of the present invention increasing the diameter of the seed crystal and/or shortening the length of the neck portion do not cause such problems. Therefore, it is a preferred aspect of the invention to use a seed crystal having a diameter of at least 5 mm in case that the single crystal is expected to exert a load on the seed crystal which is greater than 300 kg.

### Brief Description of the Drawings

Fig. 1 is a flowchart for illustrating a method of manufacturing a silicon single crystal according to this invention.
Fig. 2 is a schematic diagram for illustrating the method of manufacturing a silicon single crystal shown in Fig. 1.
Fig. 3 is a schematic diagram for illustrating the method of manufacturing a silicon single crystal shown in Fig. 1.
Fig. 4 is a photograph of a cross-section of a sample according to an Example of the present invention.
Fig. 5 is a photograph of a cross-section of a sample according to a Comparative Example.

### Best Modes for Carrying Out the Invention

An embodiment of the present invention will be described hereinafter with reference to the drawings. It is noted that the same or corresponding elements in the drawings below have the same reference numerals allotted and description thereof will not be repeated.

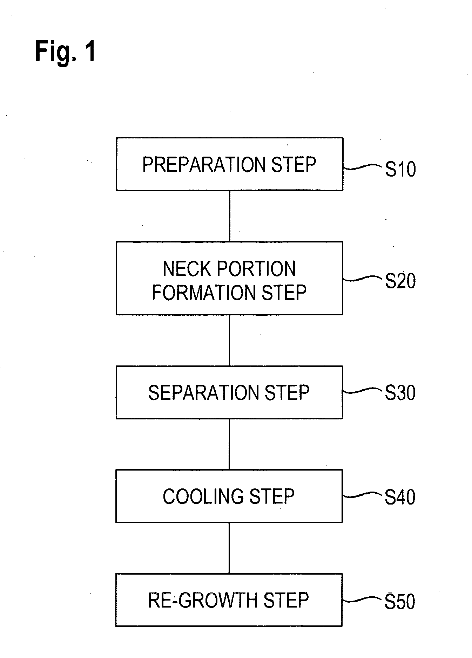

An embodiment of a method of manufacturing a silicon single crystal according to the present invention will be described with reference to Figs. 1 to 3.

Referring to Fig. 1, in the embodiment of the method of manufacturing a silicon single crystal according to the present invention, initially, a preparation step (S10) is performed. In the step (S10), a crucible arranged in a chamber of a silicon single crystal manufacturing apparatus is filled with a silicon source material. Thereafter, the silicon source material is molten by being heated, to thereby prepare a silicon melt. Here, a dopant (an impurity) is added as appropriate to the silicon source material, in accordance with characteristics of a silicon single crystal to be formed. As a dopant, for example, a group V element such as phosphorus (P) and arsenic (As) representing an n-type impurity, a group III element such as boron (B), aluminum (Al), gallium (Ga), and indium (In) representing a p-type dopant, or the like can be employed.

In the present embodiment, semiconductor-grade silicon is employed as the silicon source material. Semiconductor-grade silicon is a silicon source material lower in impurity concentration than metallurgical-grade silicon (that is, higher in silicon purity). Semiconductor-grade silicon has silicon purity, for example, of 99.999999999% (11N).

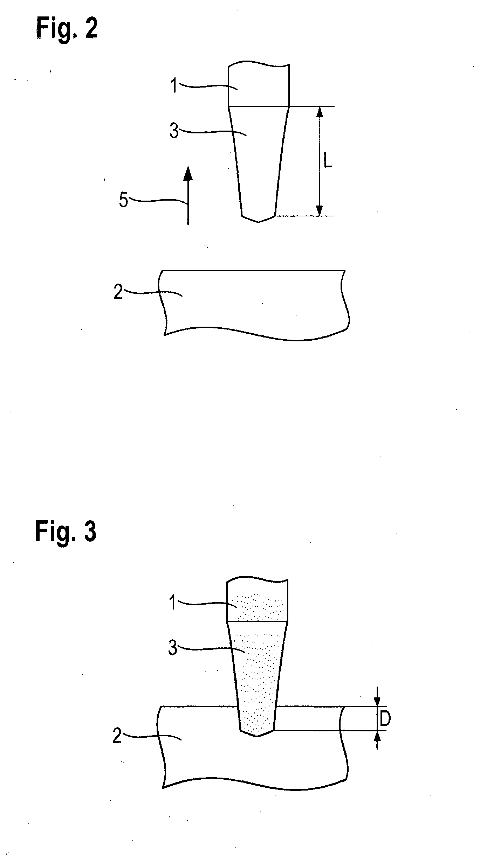

A single dopant or a plurality of, that is, two or more, types of dopants may be added to the silicon source material. In a case where a plurality of types of dopants are added to a silicon source material, all types of dopants may simultaneously be added to the silicon melt or each dopant may be added individually. It is noted that a silicon single crystal having relatively high resistivity not lower than 1 Ωcm can be used as a seed crystal 1 (see Fig. 2).

In addition, in the silicon single crystal manufacturing apparatus, seed crystal 1 (see Fig. 2) is arranged in an upper portion of the crucible in which the silicon melt is held, with the seed crystal being fixed at a tip end portion of a pull-up wire. It is noted that the pull-up wire is vertically movable by means of a drive device for pulling up a silicon single crystal grown under seed crystal 1.

Then, as shown in Fig. 1, a neck portion formation step (S20) is performed. In this step (S20), seed crystal 1 fixed at the tip end of the pull-up wire is brought down to a surface of a silicon melt 2 (see Fig. 2) and immersed therein. Thereafter, the pull-up wire is wound up by the drive device to thereby grow a neck portion (see Fig. 2) under seed crystal 1.

Then, as shown in Fig. 1, a separation step (S30) is performed. In this step (S30), by increasing a speed of wind-up of the pull-up wire by the drive device, neck portion 3 is separated from the surface of silicon melt 2 in a direction shown with an arrow 5, as shown in Fig. 2. Here, a length L of neck portion 3 is formed, for example, to be not smaller than 30 mm, more preferably not smaller than 40 mm, and further preferably not smaller than 50 mm. Then, as shown in Fig. 1, a cooling step (S40) is performed. In this step (S40), a formation temperature of the neck portion 3 is decreased to 740°C or lower. As a method of cooling the neck portion 3, any such method as spraying neck portion 3 with an inert gas or the like while seed crystal 1 and neck portion 3 are held in the chamber of the silicon single crystal manufacturing apparatus can be employed. In addition, neck portion 3 and seed crystal 1 sufficiently cooled may be taken out of the chamber and held at a room temperature. Thus, dislocation formed in neck portion 3 is anchored.

Then, as shown in Fig. 1, a re-growth step (S50) is performed. In this step (S50), as shown in Fig. 3, neck portion 3 once separated from silicon melt 2 and cooled is again brought in contact with silicon melt 2. Specifically, a tip end portion of neck portion 3 is immersed in silicon melt 2 by a prescribed length D. Length D can be, for example, not smaller than 10 mm and not greater than 20 mm and more preferably not smaller than 12 mm and not greater than 15 mm. Then, after the tip end portion of neck portion 3 is immersed in silicon melt 2 for a prescribed time period, pull-up of seed crystal 1 is again started.

By thus performing what is called the dash necking step, a cone growth step (a step of gradually increasing a diameter of a silicon single crystal from the neck portion to a prescribed diameter of the straight part of ingot), a straight-part-of-ingot growth step (a step of growing the straight part of ingot made of the silicon single crystal having a substantially constant diameter by a prescribed length), and a separation step (a step of separating the silicon single crystal from the silicon melt) are performed. The silicon single crystal can thus be obtained. As described above, neck portion 3 in which dislocation has been anchored by cooling once now serves as a new seed crystal and then the step (S50) is performed. Therefore, in the silicon single crystal grown under neck portion 3 in the step (S50), generation of dislocation is suppressed. Thus, a high-quality silicon single crystal where generation of dislocation is suppressed can be obtained. Although partially overlapping with the embodiment described above, characteristic features of the present invention will be listed here.

The method of manufacturing a silicon single crystal according to this invention includes the steps of preparing silicon melt 2 (the preparation step (S10)), forming neck portion 3 continuing from seed crystal 1 by bringing seed crystal 1 in contact with silicon melt 2 (the neck portion formation step (S20)), separating neck portion 3 from silicon melt 2 (the separation step (S30)), decreasing a temperature of neck portion 3 separated from silicon melt 2 from a temperature of neck portion 3 in the neck portion formation step (S20) (the cooling step (S40)), and forming a silicon single crystal continuing from neck portion 3 by again bringing neck portion 3 in contact with silicon melt 2 after the cooling step (S40) (the re-growth step (S50)).

By doing so, at neck portion 3 once separated from silicon melt 2, even dislocation formed around the center of neck portion 3 is immobilized, owing to an effect of anchoring of dislocation resulting from presence of an impurity. Therefore, takeover of dislocation to a silicon single crystal grown in the step of forming a silicon single crystal continuing from neck portion 3 by again bringing neck portion 3 in contact with silicon melt 2 (the re-growth step (S50)) is less likely.

In addition, even in a case where dislocation around the center of the neck portion is taken over to the grown silicon single crystal when the silicon single crystal is grown by again bringing neck portion 3 in contact with silicon melt 2, a position of the dislocation is displaced by again bringing neck portion 3 in contact with silicon melt 2. Consequently, since outward diffusion (elimination) of the dislocation is promoted by climb of dislocation, generation of dislocation extending as far as the straight part of ingot of the silicon single crystal is suppressed.

Moreover, neck portion 3 grown from seed crystal 1 has few irregularity defects because it has not been machined. Therefore, generation of dislocation from a surface of neck portion 3 brought in contact with silicon melt 2 can be suppressed in the grown silicon single crystal. Further, since a time period during which neck portion 3 again brought in contact with silicon melt 2 is held at a high temperature is also consequently longer than in the conventional example, elimination of glide dislocation is promoted as compared with the conventional example. Furthermore, neck portion 3 again brought in contact with silicon melt 2 can be smaller in area of a region in contact with silicon melt 2 than seed crystal 1. In this case, a volume and a thermal capacity of a portion of neck portion 3 in contact with silicon melt 2 can be smaller than those of a portion of seed crystal 1 in contact with silicon melt 2. Therefore, thermal shock generated at the time when neck portion 3 is brought in contact with silicon melt 2 is less than thermal shock generated at the time when seed crystal 1 is brought in contact with silicon melt 2. Consequently, generation of dislocation resulting from the thermal shock is suppressed.

In the method of manufacturing a silicon single crystal above, seed crystal 1 may have resistivity not lower than 1 Ωcm and the silicon single crystal may have resistivity not higher than 0.05 Ωcm, preferably not higher than 0.005 Ωcm. In this case, seed crystal 1 relatively high in resistance (that is, low in impurity concentration) is used to form a silicon single crystal relatively low in resistance (that is, high in impurity concentration). In such a case, dislocation is likely due to thermal shock or lattice mismatch at a portion of contact between seed crystal 1 and silicon melt 2. Namely, according to the studies conducted by the inventors, when a seed crystal has resistivity not lower than about 1 Ωcm, the seed crystal is substantially the same in lattice constant as a non-doped silicon single crystal. Then, in a case where a silicon single crystal to be formed has resistivity not higher than 0.05 Ωcm, preferably not higher than 0.005 Ωcm, probability of occurrence of a problem of generation of dislocation extending from neck portion 3 to the straight part of ingot as described above is particularly high. Therefore, the present invention is particularly effective in a case where a silicon single crystal is formed under the conditions as described above.

In the method of manufacturing a silicon single crystal above, in the cooling step (S40) of decreasing the temperature of the neck portion from the formation temperature, the temperature of the neck portion 3 is decreased to 740°C or lower. Here, since a transition temperature of ductility and brittleness of silicon is not higher than about 740°C, dislocation in neck portion 3 can reliably be fixed by decreasing a temperature of neck portion 3 to 740°C or lower. Namely, by lowering the temperature of neck portion 3 as above, dislocation in neck portion 3 is immobilized, and further introduction of an impurity (such as oxygen or boron) to a position of dislocation contributes to anchoring of the dislocation. Then, as a secondary defect (such as a precipitated substance) is formed at the position of dislocation, the dislocation is strongly anchored (locked).

Here, in a case where phosphorus (P) is employed as an impurity to be contained in a silicon single crystal forming neck portion 3 or the like, in the silicon single crystal high in concentration of phosphorus, a diffusion coefficient of oxygen is higher than in a silicon single crystal relatively low in concentration of phosphorus. Therefore, even in a case where the neck portion is held at such a low temperature as 740°C or lower, oxygen can sufficiently move in the silicon single crystal forming neck portion 3 and hence formation of a secondary defect (a precipitated substance) containing oxygen, resulting from oversaturation of oxygen due to lowering in temperature, is promoted. Consequently, dislocation can reliably be anchored. In addition, an effect of anchoring of dislocation as above will not immediately disappear even when neck portion 3 is heated to 740°C or higher by again bringing neck portion 3 in contact with silicon melt 2.

It is noted that a cooling temperature for neck portion 3 may be set to a room temperature. For example, dislocation can be anchored as above also by performing the steps up to the separation step (S30) of separating neck portion 3 from silicon melt 2 and thereafter lowering a temperature of neck portion 3 to a room temperature. Therefore, by preparing in advance seed crystal 1 having neck portion 3 formed and cooled to a room temperature, seed crystal 1 having neck portion 3 formed can be used to perform the step of forming a silicon single crystal at any time (the step similar to the step of forming a silicon single crystal with the CZ process with the use of a normal seed crystal).

In the method of manufacturing a silicon single crystal above, in the re-growth step (S50) of forming a silicon single crystal, when neck portion 3 is again brought in contact with silicon melt 2, a depth of immersion (length D in Fig. 3) of neck portion 3 into a liquid surface of silicon melt 2 may be not smaller than 10 mm and not greater than 20 mm. In this case, a silicon single crystal continuing from neck portion 3 can reliably be grown. Alternatively, from a different point of view, neck portion 3 may be formed to have a diameter gradually decreasing from the seed crystal 1 side toward the tip end side. Further, the depth of immersion above (length D in Fig. 3) may be determined such that a position where a diameter of neck portion 3 is greater by at least 1 mm than a diameter of neck portion 3 on the tip end side (a minimum diameter), more preferably a position where a diameter of neck portion 3 is greater by at least 2 mm than the minimum diameter, is in contact with the silicon melt.

In the method of manufacturing a silicon single crystal above, in the neck portion formation step (S20), length L (see Fig. 2) of formed neck portion 3 may be not smaller than 30 mm. In this case, the step of again bringing neck portion 3 in contact with silicon melt 2 can readily be performed. It is noted that length L of neck portion 3 formed in the neck portion formation step (S20) is preferably longer by at least 5 mm than length D by which neck portion 3 is immersed in silicon melt 2 in the re-growth step (S50). In addition, in an actual operation, also in consideration of ease in control or the like, length L of neck portion 3 is longer by at least 10 mm and more preferably by at least 20 mm than length D by which neck portion 3 is immersed in silicon melt 2 in the re-growth step (S50).

### Experimental Example

In order to confirm effects of the present invention, the following experiment was conducted.

A seed crystal made of a non-doped silicon single crystal was prepared. The seed crystal had resistivity not lower than 50 Ωcm. This seed crystal was used to form a silicon single crystal having low resistance and doped with phosphorus (P), with the method of manufacturing a silicon single crystal according to the present invention. It is noted that 10 silicon single crystals were manufactured and resistivity at the top of each silicon single crystal was around 0.0012 Ωcm.

The method of manufacturing a silicon single crystal according to the present invention shown in Figs. 1 to 3 was basically employed as the method of manufacturing a sample in this Example. Specifically, length L of neck portion 3 (see Fig. 2) separated from the silicon melt in the separation step (S30) was set to 60 mm. In addition, in the cooling step (S40), the neck portion was cooled to a temperature of 400°C. Then, in the re-growth step (S50), length D by which neck portion 3 is immersed in silicon melt 2 as shown in Fig. 3 was set to 20 mm. Then, after growth of the silicon single crystal was resumed, the neck portion was formed to a length of 110 mm and thereafter the cone growth step was performed so that a diameter of the silicon single crystal attained to a value exceeding 200 mm. Then, the straight-part-of-ingot growth step and the separation step were performed.

### Comparative Example

Basically under the process conditions the same as those for the sample in Example above, a silicon single crystal according to Comparative Example was manufactured. It is noted that the silicon single crystal was manufactured in Comparative Example by bringing the seed crystal in contact with the silicon melt and pulling up the silicon single crystal without performing the separation step (S30) and the cooling step (S40) as in Example above of the present invention. Ten silicon single crystals were manufactured also in Comparative Example.

The samples (silicon single crystals) in Example and Comparative Example above were vertically sliced to a thickness of 1 mm across the center (the central portion) in a direction of width of the neck portion. Then, a surface of a test piece obtained by slicing was etched with fluoric-nitric acid to remove residual strain by machining, and thereafter the surface was observed with X-ray topography. It is noted that, since dislocation extending from the neck portion to the straight part of ingot is a dislocation defect propagating around the center of the neck portion perpendicularly to a growth interface, such dislocation can substantially reliably be detected with such a method.

The obtained silicon single crystal was subjected to a prescribed process such as circumferential polishing and thereafter the silicon single crystal was sliced to fabricate a silicon substrate. Then, whether a defect was generated in a main surface of the silicon substrate or not was inspected. If even a single dislocation defect is found in the silicon substrate obtained from one silicon single crystal, it is counted as generation of a defect. It is noted that a defect can be detected in an actual operation in a stage of inspection with a foreign-matter inspection apparatus (specifically, SP1) after an epitaxial layer was deposited on the main surface of the silicon substrate. In addition, the dislocation defect above is actually observed at substantially the same site of the silicon substrate that is cut continuously from one silicon single crystal. Moreover, as the dislocation defect, for example, such a defect as slip dislocation is detected as a defect in a feather pattern.

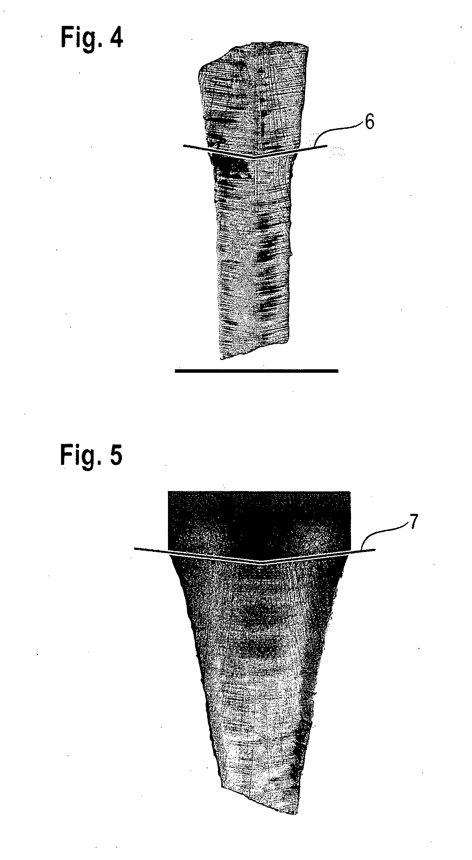

Fig. 4 is a photograph showing a cross-section of the neck portion in the sample according to Example of the present invention, and an upper side of a boundary portion 6 is the neck portion formed in the neck formation step (S20) and a lower side of boundary portion 6 is the neck portion formed in the re-growth step (S50) (a re-grown neck portion). As can be seen in Fig. 4, new dislocation was substantially not generated under boundary portion 6. In addition, dislocation propagating beyond boundary portion 6 substantially reached a side surface of the neck portion under boundary portion 6 and then disappeared.

On the other hand, Fig. 5 is a photograph showing a cross-section of the neck portion in the sample according to Comparative Example, and an upper side of a boundary portion 7 is the seed crystal and a lower side of boundary portion 7 is the neck portion. As can be seen in Fig. 5, in the sample according to Comparative Example, many dislocation defects were generated from boundary portion 7 toward the neck portion and the dislocation defects extended such that they extended along the center of the neck portion substantially perpendicularly to boundary portion 7.

With regard to the sample in Example, in 10 silicon single crystals according to Example, no defect in the surface of the substrate was observed. Namely, a ratio of generation of defects was 0%. On the other hand, in the silicon single crystals according to Comparative Example, generation of defects was observed in 6 of 10 silicon single crystals. Namely, a ratio of generation of defects was 60%.

It should be understood that the embodiment and the example disclosed herein are illustrative and non-restrictive in every respect. The scope of the present invention is defined by the terms of the claims, rather than the description above, and is intended to include any modifications within the scope and meaning equivalent to the terms of the claims.

This invention is advantageously applied to a method of manufacturing a silicon single crystal in particular with the Czochralski process.

## Claims

1. A method of manufacturing a silicon single crystal, comprising the steps of:
preparing a silicon melt;
bringing a seed crystal in contact with the silicon melt;
forming a neck portion continuing from the seed crystal, the neck portion having a formation temperature and a formation length;
separating the neck portion from the silicon melt;
decreasing a temperature of the neck portion separated from the silicon melt from the formation temperature to a temperature which is 740 °C or lower;
bringing the neck portion having the temperature which is 740 °C or lower into contact with the silicon melt; and
forming a silicon single crystal continuing from the neck portion.

2. The method of manufacturing a silicon single crystal according to claim 1, wherein said seed crystal has a resistivity of not lower than 1 Ωcm and the silicon single crystal has resistivity not higher than 0.05 Ωcm.

3. The method of manufacturing a silicon single crystal according to claim 1 or claim 2, further comprising
immersing the neck portion having the temperature which is lower than the formation temperature into the silicon melt to a depth of immersion which is not smaller than 10 mm and not greater than 20 mm.

4. The method of manufacturing a silicon single crystal according to any one of claims 1 to 3, wherein the formation length of the neck portion is not smaller than 30 mm.

5. The method of manufacturing a silicon single crystal according to any one of claims 1 to 4, wherein the seed crystal has a diameter which is not less than 5 mm.

## Patentansprüche

1. Verfahren zur Herstellung eines Siliciumeinkristalls, das Folgendes umfasst:
Herstellen einer Siliciumschmelze;
Inberührungbringen eines Keimkristalls mit der Siliciumschmelze;
Bilden eines von dem Keimkristall abgehenden Halsteils, wobei der Halsteil eine Bildungstemperatur und eine Bildungslänge aufweist;
Trennen des Halsteils von der Siliciumschmelze;
Verringern einer Temperatur des von der Siliciumschmelze getrennten Halsteils von der Bildungstemperatur auf eine Temperatur, die 740° C oder weniger beträgt;
Inberührungbringen des die Temperatur, die 740° C oder weniger beträgt, aufweisenden Halsteils mit der Siliciumschmelze; und
Bilden eines von dem Halsteil abgehenden Siliciumeinkristalls.

2. Verfahren zur Herstellung eines Siliciumeinkristalls nach Anspruch 1, bei dem der Keimkristall einen spezifischen Widerstand von mindestens 1 Ωcm aufweist und der Siliciumeinkristall einen spezifischen Widerstand von höchstens 0,05 Ωcm aufweist.

3. Verfahren zur Herstellung eines Siliciumeinkristalls nach Anspruch 1 oder Anspruch 2, ferner umfassend:
Eintauchen des die Temperatur, die unter der Bildungstemperatur liegt, aufweisenden Halsteils in die Siliciumschmelze bis zu einer Eintauchtiefe von mindestens 10 mm und höchstens 20 mm.

4. Verfahren zur Herstellung eines Siliciumeinkristalls nach einem der Ansprüche 1 bis 3, bei dem die Bildungslänge des Halsteils mindestens 30 mm beträgt.

5. Verfahren zur Herstellung eines Siliciumeinkristalls nach einem der Ansprüche 1 bis 4, bei dem der Keimkristall einen Durchmesser von mindestens 5 mm aufweist.

## Revendications

1. Procédé de fabrication d'un monocristal de silicium, comprenant les étapes consistant à :
préparer une masse fondue de silicium ;
mettre un germe cristallin en contact avec la masse fondue de silicium ;
former une partie de col s'étendant depuis le germe cristallin, la partie de col ayant une température de formation et une longueur de formation ;
séparer la partie de col de la masse fondue de silicium ;
abaisser la température de la partie de col séparée de la masse fondue de silicium de la température de formation à une température qui est de 740 °C ou moins ;
mettre la partie de col ayant la température qui est de 740 °C ou moins en contact avec la masse fondue de silicium ; et
former un monocristal de silicium s'étendant depuis la partie de col.

2. Procédé de fabrication d'un monocristal de silicium selon la revendication 1, dans lequel ledit germe cristallin a une résistivité supérieure ou égale à 1 Ωcm et le monocristal de silicium a une résistivité inférieure ou égale à 0,05 Ωcm.

3. Procédé de fabrication d'un monocristal de silicium selon la revendication 1 ou la revendication 2, comprenant en outre
l'immersion de la partie de col ayant la température qui est inférieure à la température de formation dans la masse fondue de silicium jusqu'à une profondeur d'immersion qui est supérieure ou égale à 10 mm et inférieure ou égale à 20 mm.

4. Procédé de fabrication d'un monocristal de silicium selon l'une quelconque des revendications 1 à 3, dans lequel la longueur de formation de la partie de col est supérieure ou égale à 30 mm.

5. Procédé de fabrication d'un monocristal de silicium selon l'une quelconque des revendications 1 à 4, dans lequel le germe cristallin a un diamètre qui est supérieur ou égal à 5 mm.
